(19) Europäisches Patentamt / European Patent Office / Office européen des brevets

(11) **EP 4 727 019 A1**

(12) **EUROPEAN PATENT APPLICATION**

(43) Date of publication:
**15.04.2026 Bulletin 2026/16**

(21) Application number: **25207553.6**

(22) Date of filing: **08.10.2025**

(51) International Patent Classification (IPC):
*H03M 13/11* (2006.01)      *H03M 13/00* (2006.01)

(52) Cooperative Patent Classification (CPC):
**H03M 13/116; H03M 13/1148; H03M 13/616;
H03M 13/6516; H03M 13/6561**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **10.10.2024 US 202463705874 P
12.03.2025 US 202519077405**

(71) Applicant: **Avago Technologies International
Sales
Pte. Limited
Singapore 768923 (SG)**

(72) Inventors:
• **Pulikkoonattu, Rethnakaran
Irvine, 92618 (US)**
• **Blanksby, Andrew
Irvine, 92618 (US)**

(74) Representative: **Dilg, Haeusler, Schindelmann
Patentanwaltsgesellschaft mbH
Leonrodstraße 58
80636 München (DE)**

(54) **SYSTEMS AND METHODS FOR CONCURRENT DECODING OF PRODUCT LIFTED LOW DENSITY PARITY CHECK (LDPC) CODES**

(57)    In some implementations, an apparatus may include a receiver and on or more processors. The one or more processors may be configured to identify a low-density parity-check (LDPC) code corresponding to a bipartite graph comprising a set of edges connected between a first set of nodes and a second set of nodes. The one or more processors may be configured to generate a first set of messages and a second set of messages using the encoded data. The one or more processors may be configured to communicate the first set of messages with the first subset and the second set of messages with the second subset, concurrently using the bipartite graph. The one or more processors may be configured to identify decoded data based at least on processing of the first set of messages and the second set of messages.

FIG. 10

## Description

### Field of the Disclosure

This disclosure generally relates to systems and methods for improving decoding and/or coding process of a communications system, including but not limited to systems and methods of concurrent decoding of product lifted low density parity check (LDPC) codes.

### Background

Error correcting codes enable information data to be exchanged between a transmitter communication system and a receiver communication system in a reliable manner. A transmitter communication system encodes the information data to obtain a codeword. The codeword is encoded information data. The transmitter communication system transmits the codeword to the receiver communication system. Due to noise in the communication channel, the transmission received by the receiver communication system may not be identical to the transmitted codeword. Encoding information data allows a receiver communication system with a proper decoding process to recover the information data from the received transmission despite such noise. For example, the transmitter communication system transmits parity bits to the receiver communication system. The parity bits allow the receiver communication system to verify whether the received transmission is a valid codeword and to correct errors in the transmission if the received transmission is not a valid codeword. In one approach, generating parity bits involves a complex process.

### Brief Description of the Drawings

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.

FIG. 1 is a diagram depicting an example communication environment with communication systems, according to one or more embodiments.
FIG. 2 is a schematic block diagram of a computing system, according to an embodiment.
FIG. 3 is a diagram depicting an example exponent matrix, according to one or more embodiments.
FIG. 4 is a diagram depicting example shifted identity matrices for generating a parity check matrix, according to one or more embodiments.
FIG. 5 is a diagram depicting an example parity check matrix, according to one or more embodiments.
FIG. 6 is a diagram depicting an example exponent matrix, according to one or more embodiments.
FIGS. 7A-7B are diagrams 700 depicting example bipartite graphs and the associated parity check matrix, according to one or more embodiments.
FIGS. 8A-8B are diagrams depicting variable and check node processing, according to one or more embodiments.
FIG. 9 is a diagram depicting the relationship between variable nodes and check nodes in a 2x LDPC graph, according to one or more embodiments.
FIG. 10 is a diagram depicting the decomposition to parallelism, according to one or more embodiments.
FIGS. 11A-11B are diagrams depicting decomposition to parallelism at the check node view, according to one or more embodiments.
FIGS. 12A-12B are diagrams depicting decomposition to parallelism at the variable node view, according to one or more embodiments.
FIG. 13 is a flow diagram showing a process for concurrent decoding of product lifted LDPC codes.

The details of various embodiments of the methods and systems are set forth in the accompanying drawings and the description below.

### Detailed Description

The following disclosure provides many different embodiments, or examples, for implementing different features of the provided subject matter. Specific examples of components and arrangements are described below to simplify the present disclosure. These are, of course, merely examples and are not intended to be limiting. For example, a first feature in communication with or communicatively coupled to a second feature in the description that follows may include embodiments in which the first feature is in direct communication with or directly coupled to the second feature and may also include embodiments in which additional features may intervene between the first and second features, such that the first feature is in indirect communication with or indirectly coupled to the second feature. In addition, the present disclosure may repeat reference numerals and/or letters in the various examples. This repetition is for the purpose of simplicity and clarity and does not in itself dictate a relationship between the various embodiments and/or configurations discussed.

Various embodiments disclosed herein are related to an apparatus including a receiver and one or more processors. The one or more processors may be configured to identify a low-density parity-check (LDPC) code corresponding to a bipartite graph comprising a set of edges connected between a first set of nodes and a second set of nodes. The LDPC code may be generated using a first LDPC code associated with a first subset of the second set of nodes and a second LDPC code associated with a second subset of the second set of nodes. The one or more processors may be configured to generate, using the encoded data, a first set of messages and a second set of messages. The one or more processors may be configured to communicate, using the bipartite graph, the first set of messages with the first subset and the second set of messages with the second subset, concurrently. The one or more processors may be configured to identify decoded data based at least on processing of the first set of messages and the second set of messages.

In some implementations, the LDPC code may be a product-lifted code generated using the first LDPC code and the second LDPC code.

In some implementations, the first set of messages may be log-likelihood ratio (LLR) values. In these implementations, the second set of messages may also be LLR values.

In some implementations, the one or more processors may be configured to cause a node of the first set of nodes to receive a message selectively from a node of the first subset of the second set of nodes or a node of the second subset of the second set of nodes.

In some implementations, the first LDPC code may be associated with a first subset of the first set of nodes and the second LDPC code may be associated with a second subset of the first set of nodes.

In some implementations, the one or more processors may be configured to in response to communicating the first set of messages and the second set of messages, process, at the second set of nodes, the first set of messages and the second set of messages to generate a third set of messages and a fourth set of messages. In some implementations, the one or more processors may be configured to communicate, using the bipartite graph, the third set of messages with the first subset of the first set of nodes and the fourth set of messages with the second subset of the first set of nodes, concurrently.

In some implementations, the one or more processors are configured to cause a node of the second set of nodes to receive a message selectively from a node of the first subset of the first set of nodes or a node of the second subset of the first set of nodes.

In one aspect, a parity check matrix defines a set of equations that are satisfied by any valid codeword. The parity check matrix may be used for encoding low density parity check ("LDPC") codes, described by Richardson and Urbanke in IEEE Transactions on Information Theory, Vol. 47, No. 2 (February 2001). Generally, many wireless and wireline communication systems use LDPC as a forward error correction coding scheme. However, the longest block length (in bit) for coded data, supported in the 802.11 standards (e.g., 802.11n-802.11be) is 1944. There may be a limited gain in a radio channel (e.g., 2x2 multiple-input and multiple-output channels) that can be achieved using the block length of 1944.

In one aspect, a base code may be product lifted. A product-lifted LDPC code may be constructed by replicating and permuting a smaller base code, resulting in a larger code with enhanced error correction capabilities and efficient hardware implementation. For example a 2x LDPC code may be constructed by replicating and permutating a 1x LDPC code. However, product lifting a code may result in a code with double the block length of the original code. For example, a product lifting a base code with a block length of 1944 may result in a code with a block length of 3888. The block length of 3888 is 2 times that of the longest code supported in 802.11n-802.11be standards (e.g., the block length of 1944). While, in some examples, the 2x LDPC code can be decomposed into two 1x LDPC codes that can be processed in parallel by conventional methods, certain structures of the 2x LDPC code may pose significant challenges for decomposition due to interdependencies of nodes. For example, LDPC structures that involve cross connections between subgroups of variable and check nodes may not be decomposed for parallel processing according to conventional methods.

To solve this problem, according to certain aspects, embodiments in the present disclosure relate to a technique to support decomposition of a 2x LDPC code with cross connections for parallel processing. In some examples, variable nodes may selectively receive messages from a first subgroup or a second subgroup of check nodes. Similarly, check nodes may selectively receive messages from a first subgroup or a second subgroup of variable nodes. For example, a multiplexer (MUX) may select nodes from which a variable node is to receive a message by dynamically routing the incoming signals based on predefined criteria or control signals. In this example, the MUX may select nodes, from a first subgroup and a second subgroup of check nodes, for a variable node to receive messages from (or vice versa). As a result, LDPC structures that involve cross connections between subgroups of variable and check nodes may be decomposed for parallel processing. This may allow 2x LDPC codes with cross connections to be decomposed into two 1x LDPC codes that can be processed in parallel according using existing hardware and/or methods.

The following IEEE standard(s), including any draft versions of such standard(s), are hereby incorporated herein by reference in their entirety and are made part of the present disclosure for all purposes: WiFi Alliance standards and IEEE 802.11 standards, including but not limited to IEEE 802.11a™, IEEE 802.11b™, IEEE 802.11g™, IEEE P802.11n™; IEEE P802.11ac™; and IEEE P802.11be™ through IEEE P802.11bn™ standards. Although this disclosure can reference aspects of these standard(s), the disclosure is in no way limited by these standard(s).

In one aspect, a parity check matrix defines a set of equations that are satisfied by any valid codeword. The parity check matrix may be used for encoding low density parity check ("LDPC") codes, described by Richardson and Urbanke in IEEE Transactions on Information Theory, Vol. 47, No. 2 (February 2001). Generally, many wireless and wireline communication systems use LDPC as a forward error correction coding scheme.

In one aspect, an LDPC code has a quasi-cyclic (QC) structure which helps in efficient encoding and decoding. In some embodiments, QC-LDPC codes may be a class of structured LDPC codes, which may be used in many practical applications including the IEEE 802.11n, 802.11ac, 802.11ax, 802.11be standards. In QC-LDPC codes, a parity check matrix has a cyclic structure that repeats itself in a quasi-cyclic manner, which can simplify the encoding and decoding processes, making QC-LDPC codes more efficient. The code block size (denoted by n) refers to a total number of coded or transmitted bits as a result of encoding data using an error correction code (e.g., LDPC). The number of information bits (denoted by k) refers to a number of bits that carry the data to be subject to the encoding using the error correction code. The code rate (denoted by R) refers to a ratio of the number of information bits to the code block size ($R=k/n$). In some embodiments, an LDPC encoder may take a block of k bits of information bits and produce n coded bits with the code rate $R=k/n$. An LDPC decoder may operate on (noisy version of) n received bits and (ideally) recover the k information bits. In some embodiments, the LDPC encoder may take a block of k bits of information bits as input, encode the block of k bits to produce a block of n coded bits with the code rate $R(=k/n)$.

Generally, a parity check matrix for a code represents equations that determine whether errors have occurred during transmission. More formally, for all valid codewords (i.e., bits produced by the encoder with no errors), the following equation can be true:

$$\mathbf{Hc=0} \ \ldots\ldots\ldots\ldots\ldots \text{ (Equation 1)}$$

In Equation 1, **"H"** is the parity check matrix, **"c"** is a codeword vector, and **"0"** is a vector of all zeroes. The parity check matrix, **H,** is one way of describing a code.

A generator matrix for a code, **G,** satisfies the following equation:

$$\mathbf{sG=c} \ \ldots\ldots\ldots\ldots\ldots \text{ (Equation 2)}$$

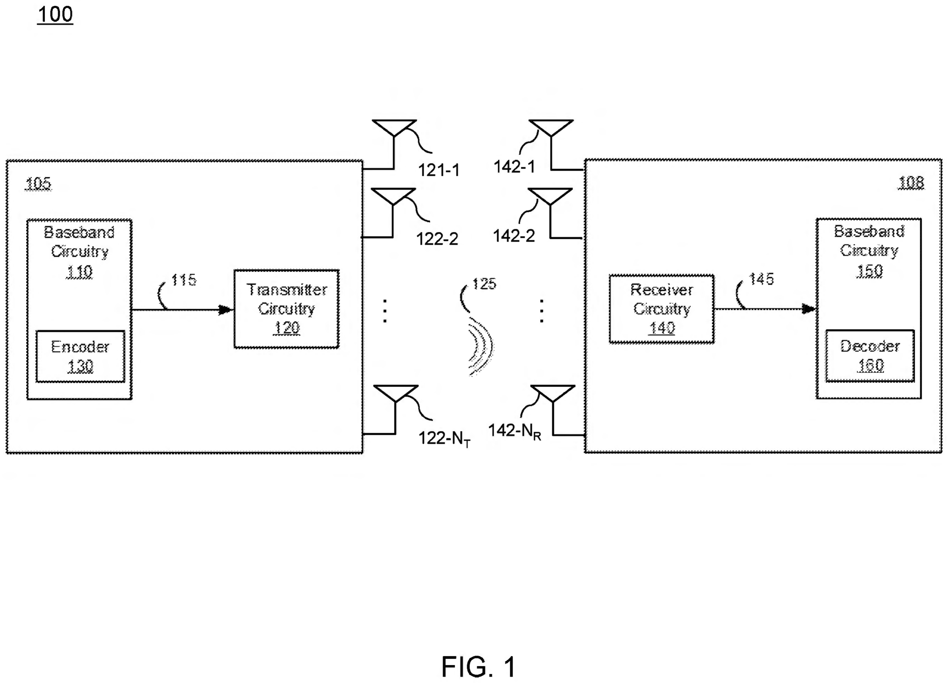

In Equation 2, **"s"** is a vector of information bits, **"G"** is a generator matrix and **"c"** is the codeword that corresponds to **"s."** In some embodiments, a system (e.g., a communication system 108 including a decoder 160 in FIG. 1) can decode the codeword c to obtain the decoded data s using Equation 2.

The parity check and generator matrices for a code are related per the above matrix equations. Generally, if a parity check matrix is low density, the corresponding generator matrix will be high density, and vice versa. LDPC codes are accordingly characterized by low density parity check matrices and high density generator matrices. The density of a matrix relates to the number of operations that must be performed to implement one of the above equations. Although it was recognized by 1995 that LDPC codes could be used to transmit data with very few errors, i.e., with error rates as good or better than turbo codes, one disadvantage of LDPC codes is that their generator matrices were high density and that made encoding computationally intensive, rending the codes impractical for many applications.

In some implementations, a parity check matrix may have a quasi-cyclic structure, for example, a parity check matrix for QC-LDPC code. Given a lifting size z, the parity check matrix may have a plurality of sub-matrices such that each submatrix is cyclically shifted version of an identity matrix of size (z x z), where z is an integer greater than 1, for example. A parity check matrix can be represented in two equivalent forms: (1) parity check matrix H and (2) a block matrix or an exponent matrix P=E(H).

In some implementations, a parity check matrix H may be a binary matrix whose size is m x n (each of m and n is an integer). Elements of the parity check matrix are binary values. Given a block length n and a code rate R, an LDPC code (or QC-LDPC code) LDPC (n, R) satisfies the following equations:

$$\mathbf{k=nR} \ \ldots\ldots\ldots\ldots\ldots \text{ (Equation 3)}$$

$$\mathbf{m=n(1\text{-}R)} \ \ldots\ldots\ldots\ldots\ldots \text{ (Equation 4)}$$

In some implementations, a block matrix or an exponent matrix (QC-LDPC exponent matrix) may be obtained. Given a lifting size z, the exponent matrix P=E(H) may have a size of m/z x n/z. If n=24z, then the size of P=E(H) is 24(1-R) x 24 (= n(1-R)/z x n/z). Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). The exponent matrix P=E(H) may have a structure including a plurality of sub-matrices (e.g., A, B, C, D, E, T).

In some implementations, a binary QC-LDPC code LDPC (n, R) may be characterized by the null space of an n(1-R)$\times$n parity check matrix H. The parity check matrix H may be a binary sparse matrix which includes a set of circulant matrices of size z x z. The parity-check matrix H of a QC-LDPC code can be represented equivalently by an exponent matrix P=E(H). This representation can help to illustrate the graphical structure of the underlying code as a base graph along with coefficient of shifting.

In some implementations, a parity check matrix H may be generated from an exponent matrix P=E(H). The exponent matrix P=E(H) may include (as elements) shift values d in the range $0<=d<z$ along with d=-1. For example, if z=7, the shift values d may include -1, 0, 1, 2, 3, 4, 5, 6. The shift value d=0 may correspond (or map) to an identity matrix of size z x z, denoted by I(z). The shift value d=-1 may correspond (or map) to a null matrix (all elements zero) of size z x z, denoted by 0*I(z). Any other integer value d in [1,z-1] may correspond (or map) to a matrix cyclically right shifted from I(z). The parity check matrix H can be obtained from the exponent matrix P=E(H) by expanding the exponent matrix P such that each element of the exponent matrix P (as a shift value d) is replaced by a matrix corresponding to the shift value.

In some implementations, the exponent matrix P=E(H) may include a plurality of elements P1,1, P1,2, P1,3, ..., P1,ń; P2,1, P2,2, P2,3, ..., P2,ń; ...; P1,1, P1,2, P1,3, ..., Pṁ,ń, which correspond to (ṁ x ń) values where ṁ and ń satisfy the following equations:

$$\acute{m}= n(1\text{-}R)/z \ \ldots\ldots\ldots\ldots\ldots \ (Equation\ 5)$$

$$\acute{n} = n/z \ \ldots\ldots\ldots\ldots\ldots \ (Equation\ 6)$$

The exponent matrix (or permutation matrix) P=E(H) may be expressed as following:

$$P \equiv E(H) = \begin{pmatrix} P_{1,1} & P_{1,2} & P_{1,3} & \cdots & \cdots & P_{1,\acute{n}} \\ P_{2,1} & P_{2,2} & P_{2,3} & \cdots & \cdots & P_{2,\acute{n}} \\ \cdots & \ddots & \ddots & \cdots & \cdots & \vdots \\ P_{\acute{m},1} & P_{\acute{m},2} & P_{\acute{m},3} & \cdots & \cdots & P_{\acute{m},\acute{n}} \end{pmatrix} \quad \ldots\ldots\ldots\ldots \ (Equation\ 7)$$

The corresponding parity check matrix H may be obtained by replacing each element of the matrix (as a shift value d) by a matrix C(d) corresponding to the shift value as follows:

$$H = \begin{pmatrix} C\left(P_{1,1}\right) & C\left(P_{1,2}\right) & C\left(P_{1,3}\right) & \cdots & \cdots & C\left(P_{1,\acute{n}}\right) \\ C\left(P_{2,1}\right) & C\left(P_{2,2}\right) & C\left(P_{2,3}\right) & \cdots & \cdots & C\left(P_{2,\acute{n}}\right) \\ \cdots & \ddots & \ddots & \cdots & \cdots & \vdots \\ C\left(P_{\acute{m},1}\right) & C\left(P_{\acute{m},2}\right) & C\left(P_{\acute{m},3}\right) & \cdots & \cdots & C\left(P_{\acute{m},\acute{n}}\right) \end{pmatrix} \quad \ldots\ldots\ldots\ldots \ (Equation\ 8)$$

For example, a matrix C(1) may be expressed as follows:

$$C(1) = \begin{pmatrix} 0 & 1 & 0 & \dots & \dots & 0 \\ 0 & 0 & 1 & \dots & \dots & \ddots \\ \ddots & \ddots & \ddots & \dots & \dots & \vdots \\ 0 & 0 & 0 & \dots & \dots & 1 \\ 1 & 0 & 0 & \dots & \dots & 0 \end{pmatrix} \quad \dots\dots\dots \text{(Equation 9)}$$

In some implementations, an encoder can produce codewords using a generator matrix (e.g., using Equation 2). In some embodiments, an encoder can use the parity check matrix (rather than the generator matrix) to produce codewords from vectors of information bits. After a parity check matrix H is obtained, the parity check matrix H may have sub-matrices A, B, C, D, T, E. An upper area O of the sub-matrix T may correspond to an area in which the matrix contains all zeroes, and the other areas may represent locations that can contain ones.

In some implementations, the codeword c can be obtained by the following expression:

$$c = [s\ p1\ p2] \dots\dots\dots \text{(Equation 10)},$$

where "s" is the vector of information bits to be encoded, "$p_1$" is a vector of the first g parity bits and "$p_2$" is a vector of the remaining m-g parity bits.

The vectors p1 and p2 can be obtained by the following equations:

$$\Phi = -ET^{-1}B+D \dots\dots\dots \text{(Equation 11)};$$

$$p_1^T = -\Phi^{-1} (-ET^{-1}A+C)\ s^T \dots\dots\dots \text{(Equation 12)};$$

and

$$p_2^T = -T^{-1} (As^T+Bp_1^T) \dots\dots\dots \text{(Equation 13)}.$$

Although various embodiments disclosed herein are described for encoding data for a wireless communication (e.g., wireless local area network (WLAN) conforming to any IEEE 802.11 standard), principles disclosed herein are applicable to other types of communication (e.g., wired communication) or any process that performs encoding for LDPC codes.

In one aspect, Ultra High Reliability (UHR) or IEEE 802.11bn (also known as "Wi-Fi 8") is a new study group within the IEEE 802.11 working group. Its purpose is to investigate PHY (physical layer) and MAC (medium access control) technologies that can enhance the reliability of WLAN (wireless local area network) connectivity. Some variants of Wi-Fi 8 chips for mobility and access are to be implemented depending on the complexity.

In one aspect, IEEE 802.11bn has new proposals of LDPC codes which are of block length 3888. These LDPC codes may have a product lifted structure. Since the block length (e.g., code block size n=3888) is 2 times more than the prevailing lengths (e.g., n=1944), a conventional decoder may have complexity in decoding such codes significantly higher than complexity in decoding existing codes.

To address this problem, according to certain aspects, embodiments in the present disclosure relate to a technique to implement and/or use concurrent and/or parallel decoding using two or more existing decoders. In some embodiments, a system can perform concurrent decoding of product lifted LDPC codes.

In some embodiments, during an update process of iterative decoding for a product lifted LDPC code (also referred to as "2xLDPC" when the lifting size=2), a graph can be suitably divided into non-overlapping subgraphs that are identical to a graph of the base code (also referred to as "1xLDPC"). This can allow two nodes (which includes, for example, two complementary check nodes and a connected pair of variable nodes) to process messages in parallel by applying an original message-passing algorithm used for the 1xLDPC graph. The decoding process can thus be split into multiple cores. A core may be an individual processing unit within a central processing unit (CPU). In some examples, the CPU may include multiple cores that are capable of independently executing individual sets of instructions. These individual sets of instructions can be processed concurrently, allowing the CPU to split independent parts of an operation (e.g., such as an LDPC decoding operation) among its cores to be processed in parallel.

In some embodiments, for iterative decoding of 2xLDPC codes, a graph can be decomposed into two identical 1xLDPC code graphs and a 1x2 bipartite graph. The 1x2 bipartite graph can be a fixed structural component determined by a lifting pattern. This composite split of the graph can be used generically for any type of message passing based decoding algorithms.

In some embodiments, rules for updating a check node (referred to as "check node update rules") can be classic belief propagation-based rules. In some embodiments, the check node update rules can be less complex versions (than classic belief propagation-based rules) such as min-sum, offset-min-sum. In some embodiments, the metric can be performed in linear, logarithmic scales.

In some embodiments, the scheduling of updating variable and check nodes (e.g., scheduling of variable and check node updates) can be selected arbitrarily. In some embodiments, any scheduling method (such as flooding, layered, permuted layered, hybrid, etc.) can be employed while still maintaining the inherent parallelism of the update process.

Systems and methods according to some embodiments can be extended to any higher order hierarchical lifted LDPC codes. For example, 4xLDPC can be treated as a hierarchical 2x2xLDPC and the scheme can be extended to 4xLDPC. Systems and methods according to some embodiments can be straightaway applicable to all type of LDPC codes (including QC-LDPC, Irregular Repeat-Accumulate (IRA) codes). For example, all the 3888-block length LDPC codes in IEEE 802.11bn/UHR can be decoded concurrently in parallel using systems and methods according to some embodiments.

Embodiments in the present disclosure have at least the following advantages and benefits. Embodiments in the present disclosure can provide useful techniques for parallel decoding, which is faster than conventional decoding schemes and may be done on two separate cores. Embodiments in the present disclosure can also reuse existing circuitry for 1xLDPC codes.

The details of various embodiments of the methods and systems are set forth in the accompanying drawings, appendix, and the description below.

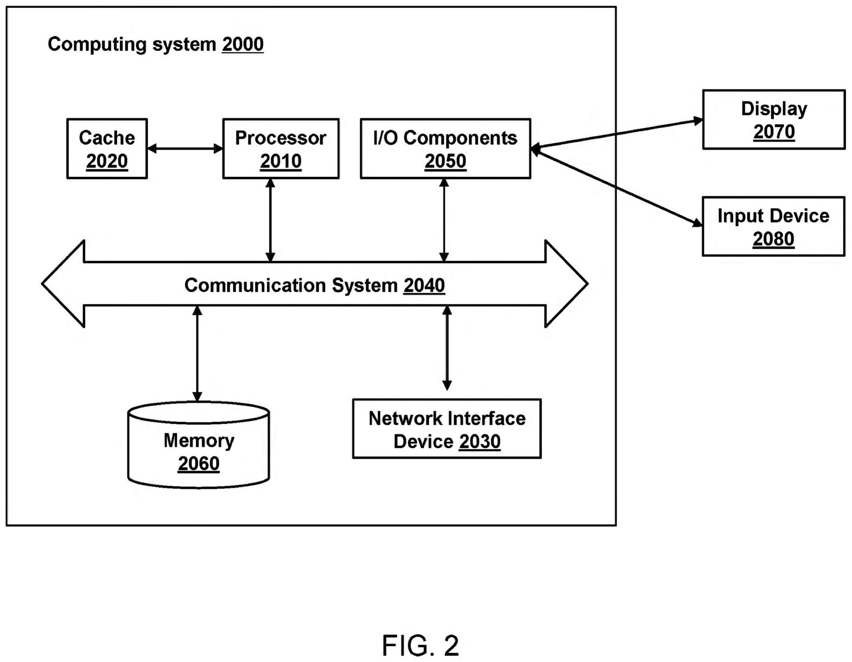

Referring to FIG. 1, illustrated is a diagram depicting an example communication environment 100 including communication systems (or communication apparatuses) 105, 108, according to one or more embodiments. In one embodiment, the communication system 105 includes a baseband circuitry 110 and a transmitter circuitry 120, and the communication system 108 includes a baseband circuitry 150 and a receiver circuitry 140. In one aspect, the communication system 105 is considered a transmitter communication system, and the communication system 108 is considered a receiver communication system. These components operate together to exchange data (e.g., messages or frames) through a wireless medium. These components are embodied as application specific integrated circuit (ASIC), field programmable gate array (FPGA), or any combination of these, in one or more embodiments. In some implementations, the communication systems 105, 108 include more, fewer, or different components than shown in FIG. 1. For example, each of the communication systems 105, 108 includes transceiver circuitry to allow bi-directional communication between the communication systems 105, 108 or with other communication systems. In some implementations, each of the communication systems 105, 108 may have configuration similar to that of a computing system 2000 as shown in FIG. 2.

The baseband circuitry 110 of the communication system 105 is a circuitry that generates the baseband data 115 for transmission. The baseband data 115 includes information data (e.g., signal(s)) at a baseband frequency for transmission. In one approach, the baseband circuitry 110 includes an encoder 130 that encodes the data and generates or outputs parity bits. In one aspect, the baseband circuitry 110 (or encoder 130) obtains a generator matrix or a parity check matrix or uses a previously produced generator matrix or a previously produced parity check matrix and encodes the information data by applying the information data to the generator matrix or the parity check matrix to obtain a codeword. In some implementations, the baseband circuitry 110 stores one or more generator matrices or one or more parity check matrices that conform to any IEEE 802.11 standard for WLAN communication. The baseband circuitry 110 retrieves the stored generator matrix or the stored parity check matrix in response to detecting information data to be transmitted, or in response to receiving an instruction to encode the information data. In one approach, the baseband circuitry 110 generates the parity bits according to a portion of the generator matrix or using the parity check matrix and appends the parity bits to the information bits to form a codeword. The baseband circuitry 110 generates the baseband data 115 including the codeword for the communication system 108 and provides the baseband data 115 to the transmitter circuitry 120.

The transmitter circuitry 120, referred to generally as transmitter(s), of the communication system 105 includes or corresponds to a circuitry that receives the baseband data 115 from the baseband circuitry 110 and transmits a wireless signal 125 according to the baseband data 115. In one configuration, the transmitter circuitry 120 is coupled between the baseband circuitry 110 and an antenna 122. In this configuration, the transmitter circuitry 120 up-converts the baseband data 115 from the baseband circuitry 110 onto a carrier signal to generate the wireless signal 125 at a radio frequency (RF) frequency (e.g., 10 MHz to 60 GHz), and transmits the wireless signal 125 through the antenna 122. In some implementations, the antenna 122 is a plurality of multiple-input and multiple-out (MIMO) antennas including transmission antennas 121-1, 122-2, ..., 122-$N_T$ (e.g., the number of transmission antennas $N_T$ is an integer greater than 1).

The receiver circuitry 140 of the communication system 108 is a circuitry that receives the wireless signal 125 from the communication system 105 and obtains baseband data 145 from the received wireless signal 125. In one configuration, the receiver circuitry 140 is coupled between the baseband circuitry 150 and an antenna 142. In this configuration, the receiver circuitry 140 receives the wireless signal 125 though the antenna 142, and down-converts the wireless signal 125 at an RF frequency according to a carrier signal to obtain the baseband data 145 from the wireless signal 125. The receiver circuitry 140 then provides the baseband data 145 to the baseband circuitry 150. In some implementations, the antenna 142 is a plurality of multiple-input and multiple-out (MIMO) antennas including receiving antennas 142-1, 142-2, ..., 142-$N_R$ (e.g., the number of receiving antennas $N_T$ $N_R$ is an integer greater than 1).

The baseband circuitry 150 of the communication system 108 includes or corresponds to a circuitry that receives the baseband data 145 from the receiver circuitry 140 and obtains information data from the received baseband data 145. In one embodiment, the baseband circuitry 150 includes a decoder 160 that extracts information and parity bits from the baseband data 145. The decoder 160 decodes the baseband data 145 to obtain the information data generated by the baseband circuitry 110 of the communication system 105.

In some implementations, each of the baseband circuitry 110 (including the encoder 130), the transmitter circuitry 120, the receiver circuitry 140, and the baseband circuitry 150 (including the decoder 160) may be as one or more processors, application specific integrated circuit (ASIC), field programmable gate array (FPGA), or any combination of them.

FIG. 2 is a schematic block diagram of a computing system, according to an embodiment. An illustrated example computing system 2000 includes one or more processors 2010 in direct or indirect communication, via a communication system 2040 (e.g., bus), with memory 2060, at least one network interface controller 2030 with network interface port for connection to a network (not shown), and other components, e.g., input/output ("I/O") components 2050. Generally, the processor(s) 2010 will execute instructions (or computer programs) received from memory. The processor(s) 2010 illustrated incorporate, or are connected to, cache memory 2020. In some instances, instructions are read from memory 2060 into cache memory 2020 and executed by the processor(s) 2010 from cache memory 2020. The computing system 2000 may not necessarily contain all of these components shown in FIG. 2 and may contain other components that are not shown in FIG. 2.

In more detail, the processor(s) 2010 may be any logic circuitry that processes instructions, e.g., instructions fetched from the memory 2060 or cache 2020. In many implementations, the processor(s) 2010 are microprocessor units or special purpose processors. The computing device 2050 may be based on any processor, or set of processors, capable of operating as described herein. The processor(s) 2010 may be single core or multi-core processor(s). The processor(s) 2010 may be multiple distinct processors.

The memory 2060 may be any device suitable for storing computer readable data. The memory 2060 may be a device with fixed storage or a device for reading removable storage media. Examples include all forms of volatile memory (e.g., RAM), non-volatile memory, media and memory devices, semiconductor memory devices (e.g., EPROM, EEPROM, SDRAM, and flash memory devices), magnetic disks, magneto optical disks, and optical discs (e.g., CD ROM, DVD-ROM, or Blu-Ray® discs). A computing system 2000 may have any number of memory devices 2060.

The cache memory 2020 is generally a form of computer memory placed in close proximity to the processor(s) 2010 for fast read times. In some implementations, the cache memory 2020 is part of, or on the same chip as, the processor(s) 2010. In some implementations, there are multiple levels of cache 2020, e.g., L2 and L3 cache layers.

The network interface controller 2030 manages data exchanges via the network interface (sometimes referred to as network interface ports). The network interface controller 2030 handles the physical and data link layers of the OSI model for network communication. In some implementations, some of the network interface controller's tasks are handled by one or more of the processor(s) 2010. In some implementations, the network interface controller 2030 is part of a processor 2010. In some implementations, the computing system 2000 has multiple network interfaces controlled by a single controller 2030. In some implementations, the computing system 2000 has multiple network interface controllers 2030. In some implementations, each network interface is a connection point for a physical network link (e.g., a cat-5 Ethernet link). In some implementations, the network interface controller 2030 supports wireless network connections and an interface port is a wireless (e.g., radio) receiver or transmitter (e.g., for any of the IEEE 802.11 protocols, near field communication "NFC", Bluetooth, ANT, or any other wireless protocol). In some implementations, the network interface controller 2030 implements one or more network protocols such as Ethernet. Generally, a computing device 2050 exchanges data with other computing devices via physical or wireless links through a network interface. The network interface may link directly to another device or to another device via an intermediary device, e.g., a network device such as a hub, a bridge, a switch, or a router, connecting the computing device 2000 to a data network such as the Internet.

The computing system 2000 may include, or provide interfaces for, one or more input or output ("I/O") devices. Input devices include, without limitation, keyboards, microphones, touch screens, foot pedals, sensors, MIDI devices, and pointing devices such as a mouse or trackball. Output devices include, without limitation, video displays, speakers, refreshable Braille terminal, lights, MIDI devices, and 2-D or 3-D printers.

Other components may include an I/O interface, external serial device ports, and any additional co-processors. For example, a computing system 2000 may include an interface (e.g., a universal serial bus (USB) interface) for connecting input devices, output devices, or additional memory devices (e.g., portable flash drive or external media drive). In some implementations, a computing device 2000 includes an additional device such as a co-processor, e.g., a math co-processor can assist the processor 2010 with high precision or complex calculations.

The components 2090 may be configured to connect with external media, a display 2070, an input device 2080 or any other components in the computing system 2000, or combinations thereof. The display 2070 may be a liquid crystal display (LCD), an organic light emitting diode (OLED) display, a flat panel display, a solid state display, a cathode ray tube (CRT) display, a projector, a printer or other now known or later developed display device for outputting determined information. The display 2070 may act as an interface for the user to see the functioning of the processor(s) 2010, or specifically as an interface with the software stored in the memory 2060.

The input device 2080 may be configured to allow a user to interact with any of the components of the computing system 2000. The input device 2080 may be a plurality pad, a keyboard, a cursor control device, such as a mouse, or a joystick. Also, the input device 2080 may be a remote control, touchscreen display (which may be a combination of the display 2070 and the input device 2080), or any other device operative to interact with the computing system 2000, such as any device operative to act as an interface between a user and the computing system 2000.

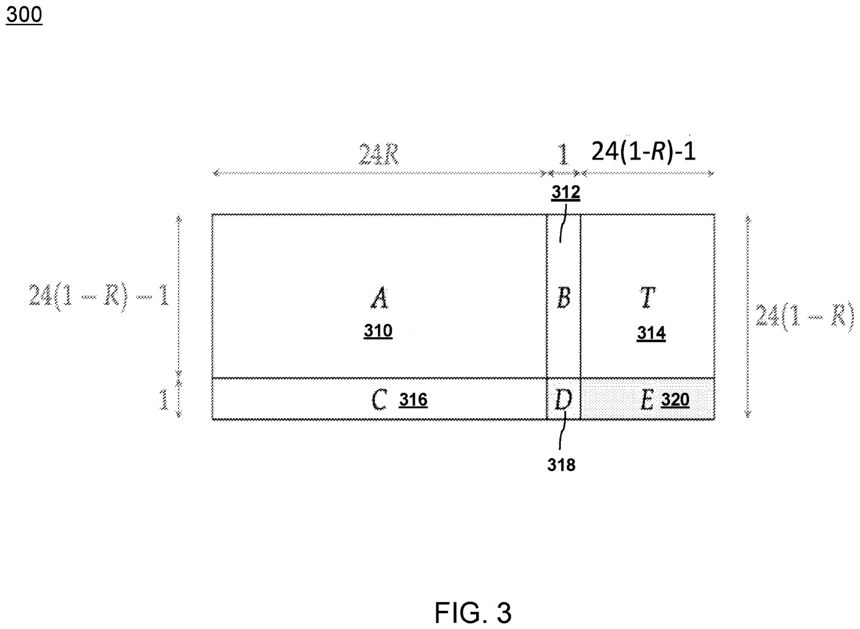

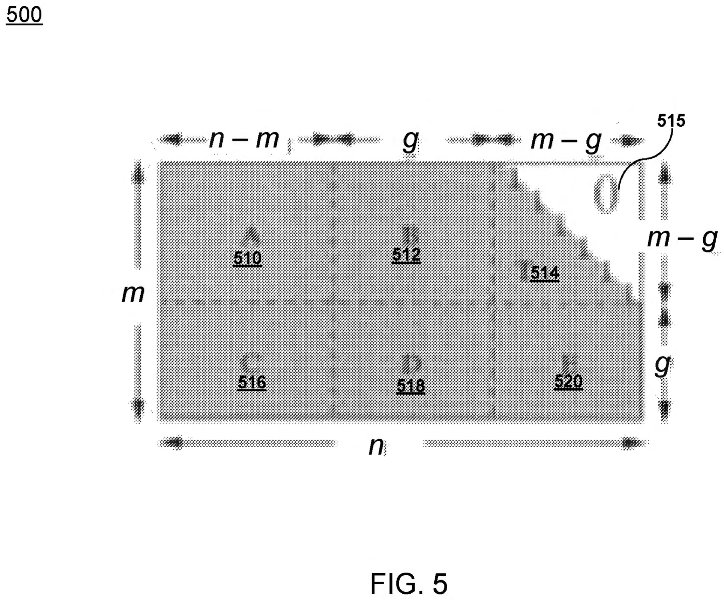

FIG. 3 is a diagram depicting an example exponent matrix (QC-LDPC exponent matrix) 300, according to one or more embodiments. Given a lifting size z, the exponent matrix 300 may have a size of m/z x n/z. If n=24z, then the size of P=E(H) is 24(1-R) x 24 (= n(1-R)/z x n/z). Elements of the exponent matrix may be integer values which correspond to cyclic shift values of identity matrix of size z x z. A parity check matrix H (see FIG. 5) may be a sparse binary matrix that can be derived from an exponent matrix P=E(H). The generator matrix G may have a size n x k in binary form (e.g., elements of the generator matrix G are binary values). Referring to FIG. 3, the exponent matrix P=E(H) may have a structure including a plurality of sub-matrices (e.g., A 310, B 312, C 316, D 318, E 320, T 314).

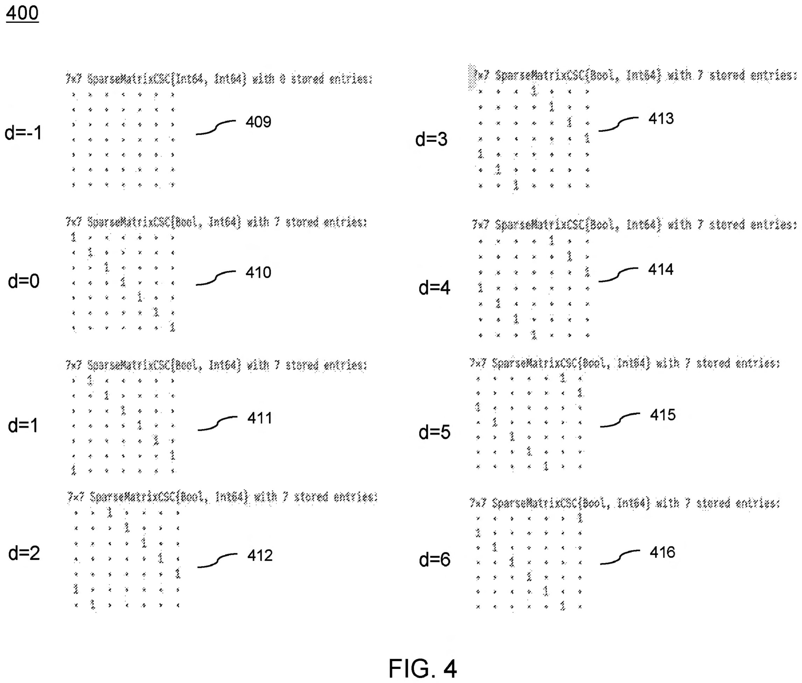

FIG. 4 is a diagram 400 depicting example shifted identity matrices 409, 410, 411, 412, 413, 414, 415, 416 for generating a parity check matrix, according to one or more embodiments. A parity check matrix H may be generated from an exponent matrix P=E(H) (e.g., exponent matrix 300) or may be identified using a codebook. As shown in Equation 7, the exponent matrix P=E(H) may include (as elements) shift values d in the range $0<=d<z$ along with d=-1. See Equation For example, if z=7, the shift values d may include -1, 0, 1, 2, 3, 4, 5, 6 (see FIG. 4). The shift value d=0 may correspond (or map) to an identity matrix of size z x z, denoted by I(z) (e.g., matrix 410). The shift value d=-1 may correspond (or map) to a null matrix (all elements zero) of size z x z, denoted by 0*I(z) (e.g., matrix 409). Any other integer value d in [1,z-1] may correspond (or map) to a matrix cyclically right shifted from I(z) (e.g., matrices 411, 412, 413, 414, 415, 416). As shown in Equation 8, the parity check matrix H can be obtained from the exponent matrix P=E(H) by expanding the exponent matrix P such that each element of the exponent matrix P (as a shift value d) is replaced by a matrix corresponding to the shift value.

FIG. 5 is a diagram depicting an example parity check matrix 500, according to one or more embodiments. In some implementations, an encoder (e.g., encoder 130) can produce codewords using a generator matrix (e.g., using Equation 2). In some implementations, an encoder (e.g., encoder 130) can use the parity check matrix (rather than the generator matrix) to produce codewords from vectors of information bits. After a parity check matrix H is obtained (e.g., using a codebook), the parity check matrix H (e.g., parity check matrix 500) may have sub-matrices A 510, B 512, C 516, D 518, T 514, E 520. An upper area O 515 of the sub-matrix T 514 (e.g., white area in FIG. 5) may correspond to an area in which the matrix contains all zeroes, and the other areas (e.g., grey area in FIG. 5) may represent locations that can contain ones. The size of the parity check matrix 500 may be m x n where the size of the sub-matrix D 518 is g x g, and the size of the sub-matrix T is (m-g)x(m-g). In some implementations, given a vector s of information bits to be encoded, the encoder can obtain a codeword c using Equation 10, Equation 11, Equation 12 and Equation 13.

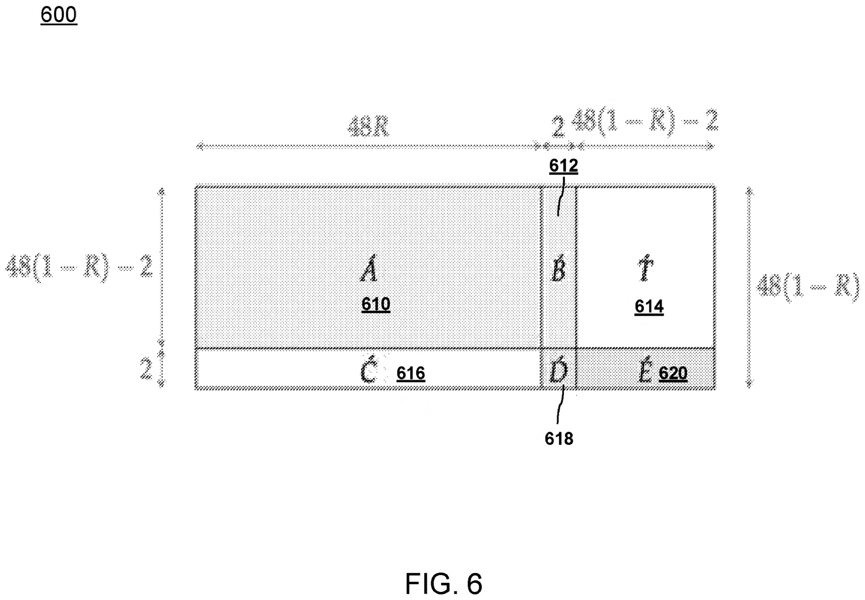

FIG. 6 is a diagram depicting an example exponent matrix (QC-LDPC exponent matrix) 600, according to one or more embodiments. Given a lifting size z, the exponent matrix 600 may have a size of m/z x n/z. If n=48z, then the size of Ṕ=E(H) matrix for n is 48(1-R) x 48 (= n(1-R)/z x n/z). Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). Referring to FIG. 6, the exponent matrix P=E(H) may have a structure including a plurality of sub-matrices (e.g., Á 610, B́ 612, Ć 616, D́ 618, É 620, T́ 614).

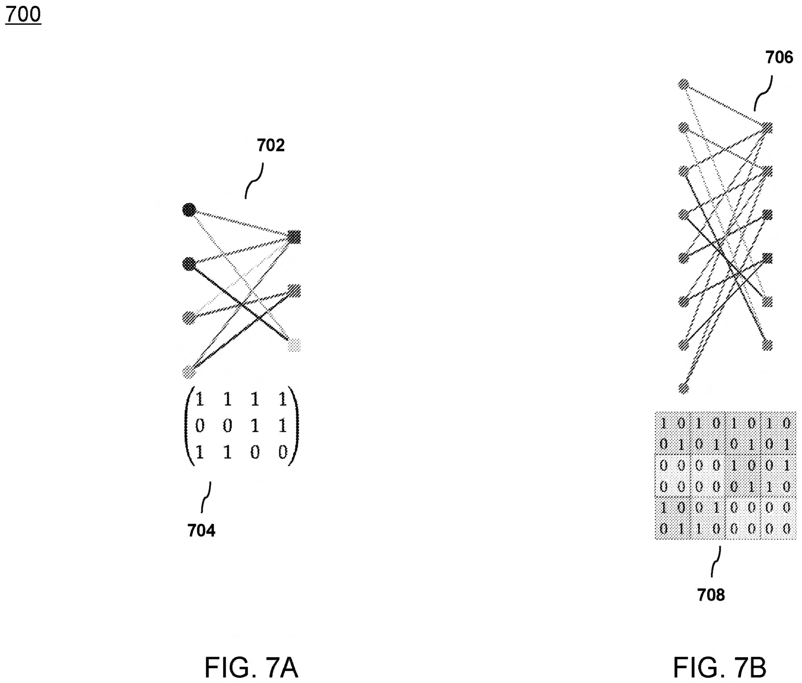

FIGS. 7A-7B are diagrams 700 depicting example bipartite graphs and the associated parity check matrix, according to one or more embodiments. In some examples, LDPC encoding may be associated with a lifting size. The lifting size may define the extent to which the base code bipartite graph is expanded. For example, a 2x LDPC code may double the block length. For instance, a double-lifted 1944 code can yield a block length of 3888.

FIG. 7A is a diagram of a base code (e.g., "1x LDPC") bipartite graph 702 and the base code parity check matrix 704, according to one or more embodiments. The bipartite graph may have two disjoint and independent vertex sets (e.g., a set of left vertexes indicated by circles and a set of right vertexes indicated by rectangles in the base code bipartite graph 702) to represent a matrix (e.g., base code parity check matrix 704). In some examples, the set of left vertices may be known as variable nodes and may represent the columns in the base code parity check matrix 704. In these examples, the set of right vertices may be known as check nodes and may represent the rows in the base code parity check matrix 704. The base code bipartite graph 702 may represent edge connections (e.g., relationships) between the variable nodes (e.g.,

columns) and the check nodes (e.g., rows) of the base code parity check matrix. In an example, the codeword may be decoded based on operations (e.g., XOR, min-sum, offset-min-sum, belief propagation, and/or the like) along the edge connections. After a certain number of iterations (e.g., determined by an iterative decoding algorithm and/or convergence criteria), a decoder may determine the value of a decoded bit based on the base code bipartite graph 702 and the base code parity check matrix 704. The check nodes may receive decoded bits (e.g., log-likelihood ratio (LLR) values) that have been determined by the variable nodes through the edge connections. Additionally, or alternatively, the base code parity check matrix 704 may also be used to determine the validity of a codeword. For example, the codeword may be multiplied by the transpose of the parity check matrix to determine the validity of the codeword. In this example, the codeword may be considered valid if the operation results in a zero vector.

FIG. 7B is a diagram of a 2x LDPC (e.g., double product lifted) bipartite graph 706 and the 2x LDPC parity check matrix 708, according to one or more embodiments. In some examples, a base code bipartite graph may be modified (e.g., permuted, moved, shifted, migrated, and/or the like, at the edge connections) to generate a 2x LDPC bipartite graph, such as the 2x LDPC bipartite graph 706. In some examples, it may be possible to decompose the 2x LDPC parity check matrix 708 into two overlapping bipartite graphs (e.g., 1x LDPC bipartite graphs) with identical degree distributions. For example, the edge connections for a given node in the first bipartite graph (e.g., $v_1$) may be the same as the edge connections for that node in the second bipartite graph (e.g., $\acute{v}_1$). The variable nodes and/or check nodes may be grouped into two sets corresponding to the two overlapping bipartite graphs that are the same size. By decomposing the 2x LDPC bipartite graph, the resulting graphs can be decoded in parallel. This enables the two bipartite graphs to be processed on separate cores, thereby reducing the need for dedicated hardware for 2x LDPC decoding and decreasing processing time.

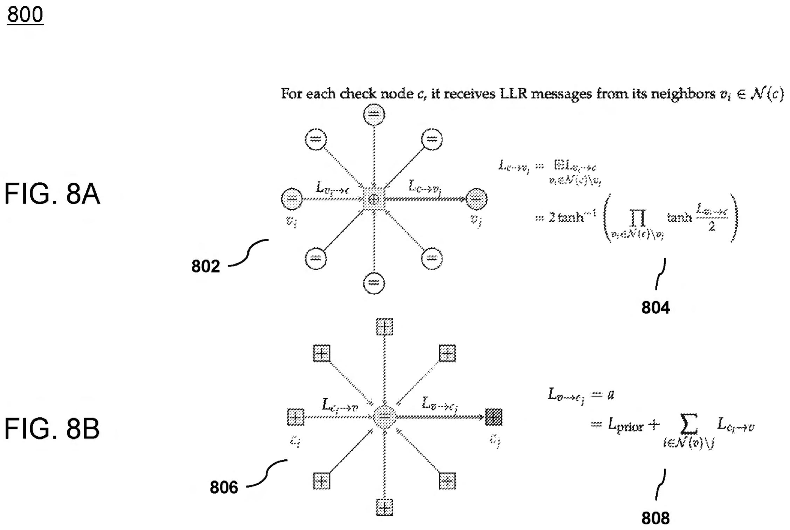

FIGS. 8A-8B are diagrams 800 depicting variable and check node processing, according to one or more embodiments. In some examples encoded data may be received by a receiver. However, in some examples the encoded data may include errors. For example, the receiver may not correctly identify a bit in the encoded data as a 1 or a 0 (e.g., due to interference, distortion, noise, and/or the like in a signal including the encoded data). In this example, an iterative decoding process using check node processing and variable node processing, such as that shown in FIG. 8A and FIG. 8B, may be used to decode the data and thereby correct misidentified values. In some examples, log-likelihood ratio (LLR) values may be generated based on the received signal including the encoded data. The LLR values may indicate a probability that a bit in the received signal is a 1 or a 0 and may be updated at each layer of an iterative decoding process using check node processing and variable node processing. A message, which is initialized based on variable nodes and the encoded data, may thereby be iteratively modified (e.g., corrected) at check nodes and variable nodes over the decoding process to generate decoded data that is a corrected version of the encoded data.

FIG. 8A is a diagram 802 of check node processing, according to one or more embodiments. The operations at the check node "c" in the diagram 802 may be represented by the equation 804. In some examples, the check node "c" may receive LLR messages (e.g., encoded messages) from its neighbor variable nodes (e.g., "$v_i \in \mathcal{N}(c)$"). For example, the check node may receive a value from the LLR message from an associated variable node based on the value in a column of a parity check matrix associated with the variable node. As an example, the check node may receive a value from the LLR message based on whether there is a 1 or a 0 in the associated value of the parity check matrix column associated with the variable node. In some examples, the neighbor nodes may be defined by the edge connections in an associated bipartite graph (e.g., such as the edge connections in the base code bipartite graph 702 of FIG. 7). For example, the check node may receive parts of the LLR message from each node that it has an edge connection to. In some examples, an operation may be performed at the check node. For example, the equation 804 may take all but one node that the check node "c" is connected to as input and output the remaining variable node (e.g., "$v_j$"). In some examples, there may be more than one layer (e.g., "L"). A layer is a grouping of rows (or columns) of the parity check matrix that can be processed in parallel as there is only a single set element in the parity check matrix in the grouped columns (or rows). For example, a layer may be a subset of the parity check matrix that corresponds to a group of variable and check nodes that are updated together in a single parallel decoding step within a decoder iteration. In examples wherein there is more than one layer, the equation 804 may be performed for the check node (e.g., "c") at each layer. At each instance (e.g., associated with a layer) of the equation, the variable (e.g., "$v_i$") may be a unique value associated with that layer.

FIG. 8B is a diagram 806 of variable node processing, according to one or more embodiments. The operation at variable node "v" in the diagram 806 may be represented by the equation 808. In some examples, the variable node "v" may receive check node values from associated check nodes. For example, the variable node may receive values from check nodes based on which check nodes the variable node has edge connections to in an associated bipartite graph. In some examples, an operation may be performed at variable node "v". For example, the equation 808 may take all but one check node that the variable node "v" is connected to as input and output the remaining check node (e.g., "$c_j$"). Similar to check node processing, variable node processing may be performed for more than one layer. In these examples, the equation may include a value from the previous layer (e.g., "$L_{prior}$"). This value may be that of the previous function (e.g., the calculation in the previous layer of "$L_{v \to c_j}$").

In some examples, decoding may be done according to a schedule. Various scheduling methods (e.g., flooding, layered, permuted layered, hybrid, and/or the like) may be used. The layers may define (e.g., schedule) an order of processing of check nodes and variable nodes within the decoding process. The decoding process may start with initializing all soft estimates with the LLR encoded message values. For example, the decoding process may be initialized as follows, wherein H is the parity check matrix:

$$Input: H, L_{in} \quad \ldots\ldots\ldots\ldots \text{(Equation 14)}$$

$$Output: \hat{c}, L_v^{out} \ldots\ldots\ldots\ldots \text{(Equation 15)}$$

$$L_{v \to c} = 0; L_{c \to v} = L_{in}; \Delta = 0 \ldots\ldots\ldots\ldots \text{(Equation 16)}$$

Based on this initialization, the LLR encoded message may be decoded using a min-sum based algorithm. For all rows in the current layer of an iteration (e.g., $v_n \in \mathcal{M}(c_m)$) the inputs from connected variable nodes may be received, the check output (e.g., min-sum offset $\Delta$) may be computed according to the following equations:

$$\lambda_{c_m \to v_n}^{sgn} \leftarrow \prod_{v_i \in \mathcal{M}(c_m) \backslash v_m} sign\left(L_{v_i \to c_m}\right) \ldots\ldots\ldots\ldots \text{(Equation 17)}$$

$$\lambda_{c_m \to v_n}^{mag} \leftarrow max(0, \Delta + \underset{v_i \in \mathcal{M}(c_m) \backslash v_m}{min} |L_{v_i \to c_m}|) \ldots\ldots\ldots\ldots \text{(Equation 18)}$$

$$L_{c_m \to v_n} \leftarrow \lambda_{c_m \to v_n}^{sgn} \lambda_{c_m \to v_n}^{mag} \ldots\ldots\ldots\ldots \text{(Equation 19)}$$

Based on the output of these equations, the soft estimate may be determined by the following equation:

$$L_{v_n}^{out} \leftarrow L_{v_n \to c_m} + L_{c_m \to v_n} \ldots\ldots\ldots\ldots \text{(Equation 20)}$$

The layer index may then be incremented, and $\hat{c}$ may be set according to the following equation:

$$if \quad L_{v_n}^{out} < 0 \ldots\ldots\ldots\ldots \text{(Equation 21)}$$

$$\hat{c}_n \leftarrow 1$$

$$else \quad \hat{c}_n \leftarrow 0$$

After the layer index has been incremented, the process starting at Equation 17 may be repeated until all layers have been processed. After the layers have been processed, the decoded bits may be updated. Finally, this process may be repeated from Equation 17 until either the syndrome (e.g., the product of the message and the parity check matrix) is satisfied. For example, the process may be repeated until the syndrome is a zero vector. This indicates a valid codeword, however the valid codeword may be the result of a mis-correction. Alternatively, the process may be repeated until the maximum number of iterations have been reached. If this process

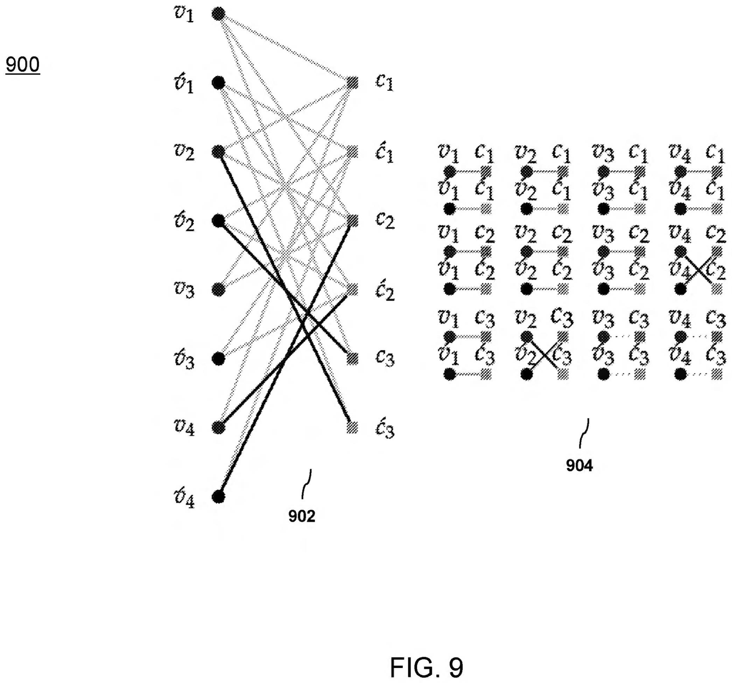

FIG. 9 is a diagram 900 depicting the relationship between variable nodes and check nodes in a 2x LDPC graph, according to one or more embodiments. The diagram 900 may be representative of a 2x LDPC, resulting in two sets of variable nodes (e.g., $v_n$ and $\acute{v}_n$) and two sets of check nodes (e.g., $c_m$ and $\acute{c}_m$) The relationships between variable nodes and check nodes may be represented by the bipartite graph 902. For example, the bipartite graph 902 may define edge connections (e.g., relationships) between the variable nodes and the check nodes. The relationship graph 904 may depict each individual connection between a variable in the two sets of variable nodes and a check node in the two sets of check nodes. As can be observed in the diagram 900, the edge connections of the first sets of variable and check nodes mirror those of the second set of variable and check nodes. For example, $c_3$ has two edges to $v_1$ and $\acute{v}_2$, and $\acute{c}_3$ has two edges to $\acute{v}_1$ and $v_2$.

In some examples, a 2x LDPC graph may be decomposed into two 1x LDPC graphs. This decomposition may simplify the decoding process, which can eliminate the need for specialized hardware, reduce the computational cost of decoding, and/or improve scalability by allowing the process to be performed on two cores. Additionally, or alternatively, decomposing the 2x LDPC code into two 1x LDPC codes may lead to faster decoding times due processing two relatively smaller codes in parallel, as opposed to linearly processing one larger code. However, in some examples, such as the example illustrated by the diagram 900, the edge connections may not allow for conventional decomposition. For example, the connections between $v_2$ and $\acute{c}_3$ and the mirrored connection between $\acute{v}_2$ and $c_3$ may prevent the bipartite graph 902 from being decomposed according to conventional methods. Similarly, the edge connections between $v_4$ and $\acute{c}_2$ and $\acute{v}_4$ and $c_2$ may also prevent the bipartite graph 902 from being decomposed according to conventional methods. As depicted in the relationship graph 904, these edge connections cross over, introducing structural complexities (e.g., cross connections) that can prevent the first set of variable and check nodes from being processed parallel to the second set of variable and check nodes.

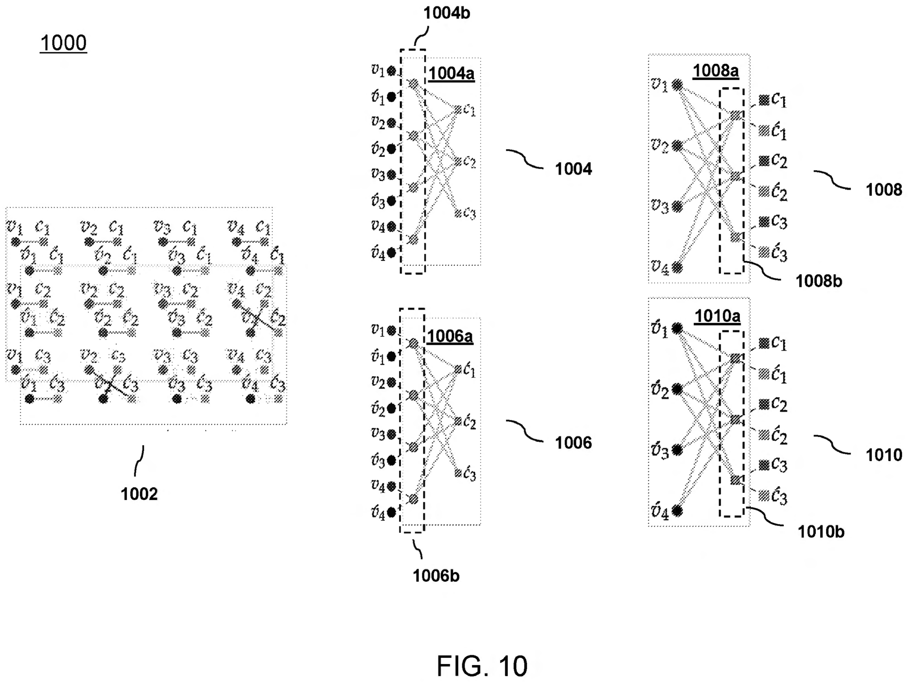

FIG. 10 is a diagram 1000 depicting the decomposition to parallelism, according to one or more embodiments. Depicted is a first check node decomposition graph 1004 for the first set of check nodes and a second check node decomposition graph 1006 for the second set of check nodes. Also depicted is a first variable node decomposition graph 1008 for the first set of variable nodes and a second variable node decomposition graph 1010 for the second set of variable nodes. Additionally, the relationship graph 1002 illustrates how the first set of checks and nodes may be processed separately from the second (e.g., prime) checks and nodes.

The first check node decomposition graph 1004 and the second check node decomposition graph 1006 depict how the first and second set of check nodes may be decomposed into parallel operations. As depicted in the first check node decomposition graph 1004 and the second check node decomposition graph 1006, the first and second sets of check nodes may be associated with graph 1004a and a graph 1006a, respectively. For example, the check node decomposition graph 1004 may include the graph 1004a and the check node decomposition graph 1006 may include the graph 1006a. During the check node update process, the graph 1004a and the graph 1006a may be share one or more edges and/or be identical. As an example, this may result in the check nodes $c_1$ and, $c_1'$ seeing identical graphs during the check node update process. In an example, the graph 1004a and the graph 1006a may be the same as the 1x LDPC graph from which the 2x LDPC graph associated with the relationship graph 1002 was generated (e.g., the bipartite graph 902 of FIG. 9). Graph 1004a may include nodes 1004b that can be connected to variable nodes in the first set of variable nodes or the second set of variable nodes. Similarly, graph 1006a may include nodes 1006b that can be connected to variable nodes in the first set of variable nodes or the second set of variable nodes. The nodes 1004b (e.g., represented by circles) within the graph 1004a and the nodes 1006b within the graph 1006a may represent an updated message that can be connected to either the variable node in the first set of variable nodes (e.g., $v_1$) or the variable node in the second set of variable nodes (e.g., $\acute{v}_1$). In some examples, the nodes associated with the updated message may be connected to the variable node in the first or second set of variable nodes based on the lifting structure. The lifting structure may be a fixed structure that transforms the base code (e.g., 1x LDPC code) bipartite graph into the double lifted (e.g., 2x LDPC code) bipartite graph by replicating and permutating nodes and edges. As an example, the top node in the nodes 1004b may be connected to $v_1$ or $\acute{v}_1$ based on the lifting structure, which may be illustrated by the relationship graph 1002. The relationship graph 1002 depicts $c_1$ as connected to $v_1$. Therefore, it can be determined that the top node in the nodes 1004b should be connected to $v_1$. In some examples, both $v_n$ and, $\acute{v}_n$ may be connected to a circle. For example, in the first check node decomposition graph 1004, both $v_4$ and $\acute{v}_4$ may be connected to the bottom node in the nodes 1004b based on edge connections associated with $c_1$ and $c_2$.

Similarly, the first variable node decomposition graph 1008 and the second variable node decomposition graph 1010 depict how the first and second sets of variable nodes may include a graph 1008a and a graph 1010a, respectively. For example, the variable node decomposition graph 1008 may include the graph 1008a and the variable node decomposition graph 1010 may include the graph 1010a. Similar to check node decomposition, the graph 1008a and the graph 1010a may be identical graphs. Additionally or alternatively, the graph 1008a and/or the graph 1010a may be the same as the 1x LDPC graph from which the 2x LDPC graph associated with the relationship graph 1002 was generated (e.g., and as a result the same graph as the graph 1004a and the graph 1006a). Graph 1008a may include nodes 1008b that can be connected to check nodes in the first set of check nodes or the second set of check nodes. Likewise, graph 1010a may include nodes 1010b that can be connected to check nodes in the first set of check nodes or the second set of check nodes. Similar to the process described above, each node in the nodes 1008b and the nodes 1010b (e.g., represented by squares) may be connected to a check node (e.g., $c_m$ or $c_m'$) based on a fix lifting structure. As an example, the top node in the nodes 1008b may be connected to $c_1$ or $\acute{c}_1$ based on the lifting structure. The relationship graph 1002 shows $v_2$ as connected to $c_1$, $c_2$, and $\acute{c}_3$, therefore the top node in the nodes 1008b can be connected to $c_1$, the second node in the nodes 1008b can be connected to $c_2$, and the third node in the nodes 1008b may be connected to $\acute{c}_3$. In some examples, both $c_m$ and, $c_m'$ may be connected to a single node in the nodes 1008b. For example, in decomposition graph 1008, both $c_3$ and, $\acute{c}_3$ may be connected to the bottom node of the nodes 1008b based on edge connection associated with $v_2$ and the edge connections associated with $v_1$.

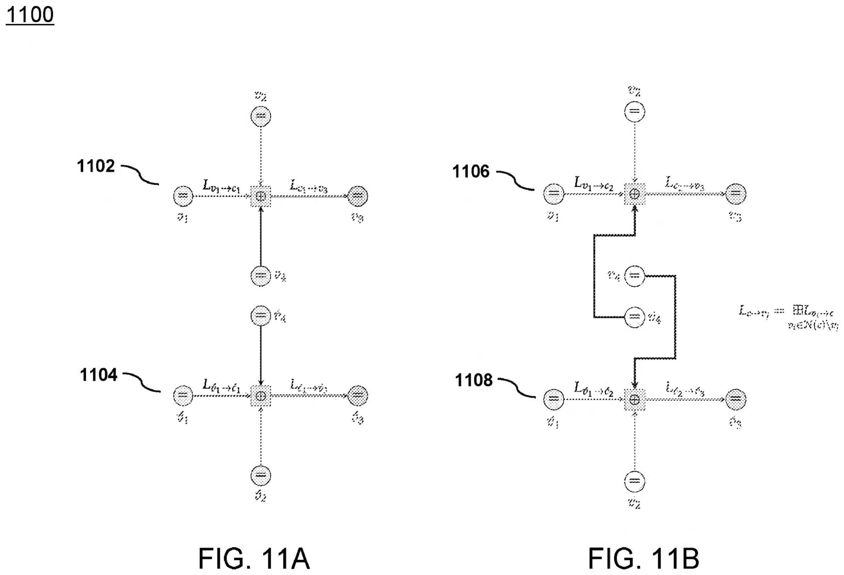

FIGS. 11A-11B are diagrams 1100 depicting decomposition to parallelism at the check node view, according to one or more embodiments. For example, FIGS. 11A-11B can depict operations at a check node for code, such as the double lifted code represented by FIG. 9. In this example, the check nodes (e.g., $c_m$) and the variable nodes (e.g., $v_n$) may be separated into a first group (e.g., $c_m$ and $v_n$) and a second group (e.g., $c'_m$ and $\acute{v}_n$). As described herein, a check node may be considered to have a cross connection when it depends on a variable node from both the first set of variable nodes and the second set of variable nodes. As depicted in the node diagrams 1102, 1104, 1106, and 1108, the check node may check whether an operation performed on input variables is equal to output variables. In some examples the operation may be an XOR function. In these examples, the check node may include a value that indicates whether the XOR of the input variable nodes should be equal to the output variable node.

FIG. 11A depicts a first node diagram 1102 and a second node diagram 1104, according to one or more embodiments. In examples where there are no cross connections between the first set of variable and check nodes and the second set of variable and check nodes, the check nodes may be calculated in parallel. As an example, $c_1$ may be calculated in parallel with $\acute{c}_1$, as depicted the first node diagram 1102 and the second node diagram 1104. The first node diagram 1102 depicts a diagram of check node $c_1$. Specifically, the diagram has variable nodes $v_1$, $v_2$, and $v_4$ as input, and node $v_3$ as output. The check nodes depicted by the first node diagram 1102 and the second node diagram 1104 may be involved in a layered scheduling decoding process, such as that described by equations 14-21 in FIG. 8. In accordance with the process described by equations 14-21, "$L_{v_1 \rightarrow c_1}$" may be initialized by the input or previous operations, while "$L_{c_1 \rightarrow v_1}$" may be determined based on equation 17 through equation 19.

FIG. 11B depicts a first node diagram 1106 and a second node diagram 1108 wherein two variable nodes have been switched between the diagrams, according to one or more embodiments. In some examples, the nodes may be switched by a multiplexer (MUX). For example, the MUX may control which variable nodes are provided as the input to the check node. In this example, the MUX may select between the first and the second set of variable nodes (e.g., $v_4$ and, $\acute{v}_4$) to allow check nodes with cross connections between the first and the second group of variable nodes, such as the check nodes depicted by the first node diagram 1106 and the second node diagram 1108, to be processed in parallel. In examples wherein the base code includes cross connections, at least some check nodes cannot be processed in parallel with conventional methods (e.g., illustrated by FIG. 11A). This may, for instance, be due to check nodes that depend on variable nodes from both the first and second set of variable nodes. For example, $c_2$ is connected to $v_1$, $v_2$, $v_3$ and $\acute{v}_4$ (e.g., as depicted in the bipartite graph 902 of FIG. 9), and therefore depends on variable nodes from both the first and second sets of variable nodes. To allow for parallel processing, check nodes may selectively receive variable nodes. For example, to process $c_2$ and, $\acute{c}_2$, the $v_4$ and, $\acute{v}_4$ nodes are swapped in the first node diagram 1106 and the second node diagram 1108. In an example, swapping the $\acute{v}_4$ node in for the $v_4$ node may be thought of as connecting the $\acute{v}_4$ to the bottom node in the nodes 1004b of FIG. 10.

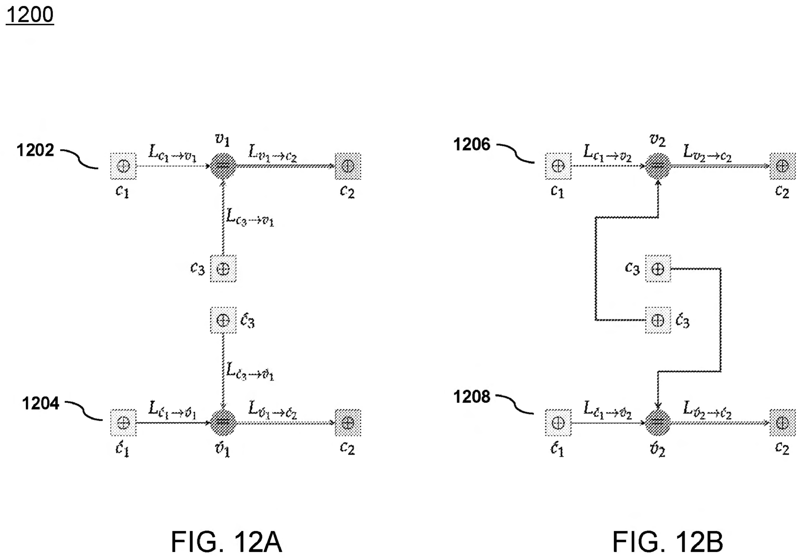

FIGS. 12A-12B are diagrams 1200 depicting decomposition to parallelism at the check node view, according to one or more embodiments. For example, FIGS. 12A-12B can depict operations at a variable node for code, such as the double lifted code represented by FIG. 9. In this example, the check nodes (e.g., $c_m$) and the variable nodes ($v_n$) may be separated into a first group (e.g., $c_m$ and $v_n$) and a second group (e.g., $c'_m$ and $\acute{v}_n$). As described herein, a variable node may be considered to have a cross connection when it depends on a check node from both the first set of check nodes and the second set of check nodes. As depicted in the node diagrams 1202, 1204, 1206, and 1208, the variable nodes (e.g., depicted by a circle with an equal sign in the middle) may represent variable node processing that has a relationship between a plurality of check nodes.

FIG. 12A depicts a first node diagram 1202 and a second node diagram 1204, according to one or more embodiments. In examples where there are no cross connections between the first set of variable and check nodes and the second set of variable and check nodes, the variable node processing may be performed in parallel based on the first node diagram 1202 and the second node diagram 1204.

FIG. 12B depicts a first node diagram 1206 and a second node diagram 1208 wherein two variable nodes have been switched between the diagrams, according to one or more embodiments. In some examples, the check nodes may be switched by a multiplexer (MUX). For example, the MUX may control which variable nodes are provided as the input to the variable node. In this example, the MUX may select between the first and the second set of check nodes (e.g., $c_3$ and, $\acute{c}_3$ to allow variable nodes with cross connections between the first and the second group of check nodes, such as the variable nodes depicted by the first node diagram 1106 and the second node diagram 1108, to be processed in parallel. In examples wherein the base code includes cross connections, at least some variable nodes cannot be processed in parallel with conventional methods (e.g., illustrated by FIG. 12A). This may, for instance, be due to check nodes that depend on check nodes from both the first and second set of variable nodes. For example, $v_2$ is connected to $c_1$, $c_2$, and $c'_3$ (e.g., as depicted in the bipartite graph 902 of FIG. 9), and therefore depends on check nodes from both the first and second sets of check nodes. However, as depicted in the first node diagram 1106 and the second node diagram 1108, nodes may be swapped to allow for a parallel processing. For example, to process $v_2$ and $\acute{v}_2$, the $c_3$ and, $\acute{c}_3$ nodes are swapped in the first node diagram 1106 and the second node diagram 1108.

As a result of swapping variable nodes as described in FIG. 11B and/or check nodes as describes in FIG. 12B, the variable nodes and the check nodes may be grouped into two sets, wherein the swapped edges allow them to be processed in parallel regardless of what scheduling algorithm is used in the decoding process. This can allow double lifted codes (e.g., 3888 block length) with cross connections to be decomposed into two base code (e.g., 1944 block length) diagrams. A double lifted code with cross connections can thus be processed with existing hardware and methods for decoding based code LDPC decoding. Described herein are examples processing 2x LDPC codes with cross connections in parallel. However, LDPC codes with cross connections that have been product lifted three times (e.g., 4x LDPC) or more can also be processed in parallel using the described systems and methods. As an example, a 4x LDPC can be treated as two 2x LDPC codes, which can each be treated as two 1x LDPC codes according to methods described herein. Furthermore, the methods and systems described herein may be applicable to all types of LDPC codes (e.g., quasi-cyclic low-density parity-check (QC-LDPC), irregular repeat accumulate (IRA), and/or the like).

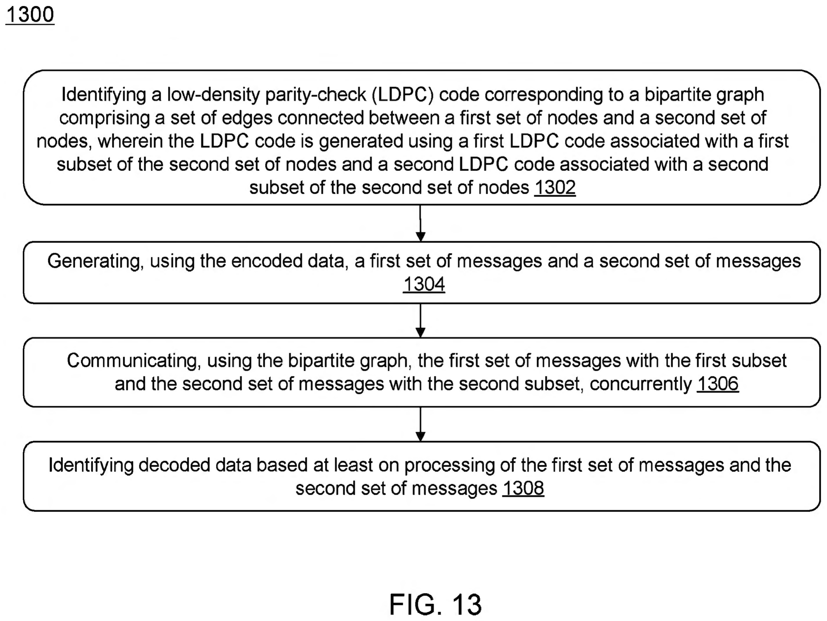

FIG. 13 is a flow diagram showing a process 1300 for concurrent decoding of product lifted LDPC codes. In some implementations, the process 1300 is performed by one or more processors (e.g. communication system 105, encoder 130, or processor 2010). In other embodiments, the process 1300 is performed by other entities. In some implementations, the process 1300 includes more, fewer, or different steps than shown in FIG. 13.

In some implementations, a receiver may be configured to receive encoded data. For example, the receiver may receive a transmission comprising of encoded data. The term receiver may refer to an antenna, demodulator, RF front-end, or any circuitry or device configured to receive encoded data. The term encoded data may refer to a signal received by the receiver that has been encoded by a parity check matrix, binary digits (e.g., 1 or 0) identified from the received signal, LLR values determined based on the received signal, or any other data representing information received by the receiver that has been encoded with a parity check matrix. As an example, the encoded data may be a signal wherein a higher amplitude represents a 1 and a lower amplitude represents a 0. In some examples, the encoded data may be transmitted to the receiver by a transmitter. For example, the transmitter may encode a communication that represents information that is to be transmitted from the transmitter to the receiver. As an example, the data bits of the communication may be arranged into a vector to generate a communication vector, the communication vector may be multiplied by a parity-check matrix to generate the parity bits, and the original data bits and the generate parity bits may be combined to form the encoded data, which can include both data bits from the communication and parity bits.

At step 1302, the one or more processors may identify a low-density parity-check (LDPC) code. For example, the one or more processors may identify the LDPC code that can be used to decode the encoded data received by the receiver. The term LDPC code refers to an error correction code, a decoding method, or any set of relationships between columns and rows in a parity check matrix that can be used to correct errors in a message encoded by the parity check matrix. For example, iterative decoding algorithms such as belief propagation can be used to efficiently identify and correct errors in encoded data based on the LDPC code. In some examples, the LDPC code may correspond to a bipartite graph (e.g., such as the bipartite graph 902 of FIG. 9) comprising a set of edges connected between a first set of nodes and a second set of nodes. The term bipartite graph refers to a graph that shows relationships between two sets of vertices, Tanner graph, or any other visual representation of the relationship between rows and columns of a parity check matrix defined by an LDPC code. For example, the LDPC code may correspond to a bipartite graph and an associated parity check matrix, wherein the first set of nodes are variable nodes that correspond to columns in the parity check matrix and the second set of nodes are check nodes that correspond to rows in the parity check matrix. The bipartite graph may be a visual depiction of the relationships (e.g., edges connected) between the first set of nodes and the second set of nodes. In some examples, the LDPC code may be generated using a first LDPC code associated with a first subset of second set of nodes and a second LDPC code associated with a second subset of the second set of nodes. For example, LDPC code can be decomposed into the first LDPC code and the second LDPC code, each corresponding to different subsets of nodes, to facilitate more efficient decoding and error correction processes. In an example, the first LDPC code may decode the encoded data in parallel with the second LDPC code.

In some implementations, the LDPC code may be product lifted. Illustrative examples are described herein of double-lifted LDPC codes (e.g., such as the LDPC code depicted by FIG. 9), however in some examples an LDPC code may be product lifted three or more times. In examples wherein the LDPC code is double lifted, the first set of nodes (e.g., variable nodes) may include a first subset (e.g., $v_n$) and a second subset (e.g., $\acute{v}_n$). Similarly, the second set of nodes (e.g., check nodes) may include a first subset (e.g., $c_m$) and a second subset (e.g., $\acute{c}_m$). In some examples wherein the LDPC code is double lifted, the LDPC code may be decomposed into a first LDPC code and a second LDPC code. For example, the LDPC code may be generated using a first LDPC code associated with the first subset of the second set of nodes and the second LDPC code may be generated using the second subset of the second set of nodes.

In some implementations, the one or more processors may cause a node of the first set of nodes to selectively receive a message from the first or second subset of the second set of nodes. For example, the one or more processors may include a multiplexer (MUX). The MUX may select a node from the second set of nodes for the node of the first set of nodes to receive. In an example, the multiplexer may cause the node of the first set of nodes to selectively receive a message from the second subset of the second set of nodes (e.g., with reference to FIG. 12B, $v_2$ may selectively receive a

message from $\acute{c}_3$). As a result, this may allow nodes in the first set of nodes that include cross-connections between the first subset and the second subset of the second set of nodes to be processed in parallel. A node in the first set of nodes may include cross-connections when, based on the LDPC code, it receives a message from both the first subset and the second subset in the second set of nodes. Using this method, the double-lifted LDPC code may still be decomposed into two 1x LDPC codes which can be processed in parallel. This may allow the double-lifted LDPC code to be processed by existing methods without specialized hardware and/or be processed more efficiently.

In some implementations, the first LDPC code may be associated with the first subset of the first set of the nodes (e.g., $v_n$ as depicted in FIG. 9). In these implementations, the second LDPC code may be associated with the second subset of the first set of nodes (e.g., $\acute{v}_n$ as described in FIG. 9). As an example, the first LDPC code may be represented by the graph 1008a of FIG. 10 and the second LDPC code may be represented by the graph 1010a. Similarly, the first LDPC code may be associated with the first subset of the second set of nodes (e.g., $c_m$). Likewise, the second LDPC code may be associated with the second subset of the second set of nodes (e.g., $c'_m$). In some examples, the first LDPC code and the second LDPC code may be identical. In some examples, the LDPC code may be generated based on the first LDPC code and the second LDPC code. For example, with reference to FIG. 10, the LDPC code may be generated based on which nodes in the second set of nodes are connected to the nodes 1008b and the nodes 1010b when the first LDPC code is associated with the first subset of the first set of nodes and the second LDPC code is associated with the second subset of the first set of nodes. Returning to FIG. 13, which nodes in the second set of nodes (e.g., check nodes) are connected to the nodes in the first LDPC code and the second LDPC code may be fixed and defined based on a lifting structure (e.g., the lifting structure based on which the double-lifted LDPC code has been generated from a 1x LDPC based code).

At step 1304, the one or more processors may generate a first set of messages and a second set of messages. The term message may refer to a bit value (e.g., (1 or 0), a value indicating the probability of a bit value (e.g., LLR value), a set of values indicating a bit value or probability of bit values, or any other set of information that can be utilized to characterize the transformation from encoded data to decoded data throughout the iterative decoding process. In an example, messages may be initialized based on variable nodes and the encoded data. During the iterative decoding process, message values may be updated (e.g., as it is passed between variable and check nodes). For example, in response to determining that a message value in a received set of messages is an error, the one or more processors may correct the message value. In some examples, message values may be the input and output of layers within the iterative decoding process. The iterative decoding process may be initialized with an initial set of messages including the encoded data. An updated set of messages may be generated at each layer, and the output of the final layer may be a final set of messages including decoded data. In some examples, this may allow for correction of the received encoded data. For example, data received by a receiver may not always be correct due to various factors such as noise, interference, or signal degradation during transmission. The iterative decoding process may allow the one or more processors to identify incorrect message values in the set of messages. In some examples, messages may be communicated between the first set of nodes and the second set of nodes. In these examples, communicating a set of messages may include communicating a message value from a first node (e.g., in the first set of nodes) to a second node (e.g., in the second set of nodes) according to an edge connection represented in a bipartite graph. As an example, communicating the first set of messages to the first subset of nodes of the second set of nodes (e.g., $c_m$) may include communicating the first set of messages (e.g., nodes 1004b) along edge connections represented by a bipartite graph (e.g., graph 1004a of FIG. 10).

In some implementations, the messages may be log-likelihood (LLR) values. The term LLR value may refer to a probability corresponding of a received bit being a 1 or a 0, a value on a scale from a negative value to a positive value wherein a higher absolute value indicates higher confidence in a determined bit value, or any other value that represents the confidence in a received bit's determined value. In some examples, LLR value may refer to a functional of LLR values, such as a related mapping of LLR values. For example, LLR value may refer to LLR values that have been multiplied by a value (e.g., -1) to map them to an index (e.g., quantizer index). In an example the first set of messages and the second set of messages may both be LLR values. The LLR values may be generated by the processor based on receiving the encoded data. For example, the encoded data may be modulated and transmitted over a communication channel. In this example, the receiver may receive a modulated signal including the encoded data. Based on the signal received by the receiver, the one or more processors may demodulate the data. Demodulating the data may include transforming the signal from an analog signal (e.g., a wave such as a sine wave) back to a digital signal (e.g., 1's and 0's). An LLR value may be the probability that an associated bit is a 0 or a 1 based on a received signal, such as the signal received by the receiver including the encoded data. In an example, the LLR value may incorporate noise characteristics of a channel through which the receiver received the encoded data. In some examples, the first set of messages and the second set of messages may each be associated with a set of bits (e.g., 8 bits). In these examples, the first and second set of messages may be a set of 8 numbers that each represent how likely each bit is to be a 0 or 1. As an example, each number may represent on a scale of -7.75, to 7.75 how likely each number is to be a 0 or a 1, wherein 7.75 indicates high likelihood of a 0 and -7.75 indicates high likelihood of a 1. In some examples of iterative decoding, this LLR value may be updated at each layer to progressively refine the bit estimates and improve error correction.

At step 1306, the one or more processors may concurrently communicate the first set of messages with the first subset of the second set of nodes and the second set of messages with the second subset of the second set of nodes. For example, the LDPC code may be a 2x LDPC code. As a result of decomposing the LDPC code into a first LDPC code and a second LDPC code (e.g., two 1x LDPC codes), the first LDPC code may be used to communicate the first set of messages to the first subset of the second set of nodes in parallel with the second LDPC code communicating the second set of messages to the second subset of the second set of nodes.

In some implementations, the messages may be updated at the second set of nodes. For example, in response to communicating the first set of messages to the second set of nodes, the first set of messages may be processed (e.g., updated) to generate a third set of messages. The second set of messages may be similarly processed to generate a fourth set of messages. In some examples, the one or more processors may communicate the third set of messages with the first subset of the first set of nodes. Similarly, the one or more processors may communicate the fourth set of messages with the second subset of the first set of nodes. In an example, the messages may be communicated based on the bipartite graph. For example, the one or more processors may communicate message values in the third set of messages to specific nodes in the first subset of nodes based on the bipartite graph.

In some implementations, a node in the second set of nodes may be configured to receive a message selectively from a node of the first subset of the first set of nodes or a node of the second subset of the first set of nodes. For example, a MUX, that is the same or similar to the MUX used to select a node from the second set of nodes to transmit a message to a node in the first set of nodes, may be configured to determine which nodes the node in the second set of nodes should receive a message from. As an example, the MUX may cause the node of the second set of nodes to selectively receive a message from a node of the second subset of the first set of nodes (e.g., with reference to FIG. 11B, $c_2$ to selectively receive a message from $\acute{v}_4$ in the second subset of the first set of nodes $\acute{v}_n$). As another example, the MUX may cause the node of the second set of nodes (e.g., $\acute{c}_2$) to selectively receive a message from the first subset of the first set of nodes (e.g., from $v_4$ in the first subset of the first set of nodes $v_n$). In some examples, the message may include a first set of messages and a second set of messages. In these examples, the MUX may determine which nodes in the first subset of the second set of nodes receive the first set of messages and which nodes in the second subset of the second set of nodes receive the second set of messages.

At step 1308, the one or more processors may identify decoded data based on processing the first set of messages and the second set of messages. The term decoded data may refer to a set of bit values corresponding to the encoded data, where one or more values have been corrected during the LDPC decoding process, a set of modified (e.g., corrected) LLR values corresponding to the encoded data, a set of bit values generated from these modified LLR values, or any other data representing a modified version of the encoded data. For example, the first set of messages and the second set of messages may be processed at the second set of nodes to generate an updated first set of messages and an updated second set of messages. In an example, the decoded data may be identified as the updated first set of messages and the updated second set of messages. Alternatively, the first and second set of messages may be passed and updated between the first set of nodes and the second set of notes iteratively until a stopping condition is met, and the decoded data may be the first and second set messages at the point that the stopping condition has been met. In an example, the stopping condition may be a threshold number of iterations. Additionally, or alternatively, the stopping condition may be a valid first and second set of messages. For example, at each iteration (e.g., update of the messages), a validity of the first and second set of messages may be determined based on multiplying them by the parity check matrix (e.g., concatenating the messages into a vector and multiplying them by the parity check matrix used to generate the encoded data). In this example, the first and second set of messages may be determined as valid if this operation results in a zero vector. In examples wherein the messages are represented by LLR values, the decoded data may be a series of 1s and 0s determined based on each indicated likelihood in the messages.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities (e.g., STAs, APs, beamformers and/or beamformees) that can operate within a system or environment. It should be understood that the systems described above can provide multiple ones of any or each of those components and these components can be provided on either a standalone machine or, in some embodiments, on multiple machines in a distributed system. Further still, bit field positions can be changed and multibit words can be used. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

**Claims**

1. A method comprising:

    receiving, by a receiver, encoded data;
    identifying, by one or more processors, a low-density parity-check (LDPC) code corresponding to a bipartite graph comprising a set of edges connected between a first set of nodes and a second set of nodes, wherein the LDPC code is generated using a first LDPC code associated with a first subset of the second set of nodes and a second LDPC code associated with a second subset of the second set of nodes;
    generating, by the one or more processors, using the encoded data, a first set of messages and a second set of messages;
    communicating, by the one or more processors, using the bipartite graph, the first set of messages with the first subset and the second set of messages with the second subset, concurrently; and
    identifying, by the one or more processors, decoded data based at least on processing of the first set of messages and the second set of messages.

2. The method of claim 1, wherein
   the LDPC code is a product lifted code generated using the first LDPC code and the second LDPC code.

3. The method of claim 1 or 2, wherein

    the first set of messages are log-likelihood ratio (LLR) values, and
    the second set of messages are LLR values.

4. The method of any one of the claims 1 to 3, further comprising:
   causing a node of the first set of nodes to receive a message selectively from a node of the first subset of the second set of nodes or a node of the second subset of the second set of nodes.

5. The method of any one of the claims 1 to 4, wherein
   the first LDPC code is associated with a first subset of the first set of nodes and the second LDPC code is associated with a second subset of the first set of nodes.

6. The method of claim 5, further comprising:

    in response to communicating the first set of messages and the second set of messages, processing, at the second set of nodes, the first set of messages and the second set of messages to generate a third set of messages and a fourth set of messages; and
    communicating, using the bipartite graph, the third set of messages with the first subset of the first set of nodes and the fourth set of messages with the second subset of the first set of nodes, concurrently.

7. The method of claim 5 or 6, further comprising:
   causing a node of the second set of nodes to receive a message selectively from a node of the first subset of the first set of nodes or a node of the second subset of the first set of nodes.

8. An apparatus comprising:

    a receiver configured to receive encoded data; and

one or more processors are configured to carry out those method steps of the method as set forth in any one of the preceding claims, which method steps are performed by the one or more processors.

9. An apparatus comprising:

a receiver configured to receive encoded data; and
one or more processors are configured to:

identify a low-density parity-check (LDPC) code corresponding to a bipartite graph comprising a first bipartite graph and a second bipartite graph, which share one or more edges, wherein the LDPC code is generated using a first LDPC code associated with the first bipartite graph and a second LDPC code associated with the second bipartite graph;
generate, using the encoded data, a first set of messages and a second set of messages;
communicate, using the first bipartite graph, the first set of messages and communicate, using the second bipartite graph, the second set of messages, concurrently; and
identify decoded data based at least on processing of the first set of messages and the second set of messages.

10. The apparatus of claim 9, wherein

the first set of messages are log-likelihood ratio (LLR) values, and
the second set of messages are LLR values.

11. The apparatus of claim 9 or 10, wherein
the LDPC code is a product lifted code generated using the first LDPC code and the second LDPC code.

12. The apparatus of any one of the claims 9 to 11, wherein

the first bipartite graph comprises a first set of edges connected between a first set of nodes and a second set of nodes, and
the second bipartite graph comprises a second set of edges connected between a third set of nodes and a fourth set of nodes.

13. The apparatus of claim 12, wherein
the one or more processors are configured to cause a node of the first set of nodes to receive a message selectively from a node of the second set of nodes or a node of the fourth set of nodes.

14. The apparatus of claim 12, wherein
the one or more processors are configured to cause a node of the second set of nodes to receive a message selectively from a node of the first set of nodes or a node of the third set of nodes.

**FIG. 1**

EP 4 727 019 A1

**Computing system 2000**

Cache 2020 ←→ Processor 2010

I/O Components 2050

Display 2070

Input Device 2080

Communication System 2040

Memory 2060

Network Interface Device 2030

FIG. 2

EP 4 727 019 A1

FIG. 3

400

FIG. 4

500

FIG. 5

FIG. 6

EP 4 727 019 A1

700

702

$$\begin{pmatrix} 1 & 1 & 1 & 1 \\ 0 & 0 & 1 & 1 \\ 1 & 1 & 0 & 0 \end{pmatrix}$$

704

FIG. 7A

706

708

FIG. 7B

EP 4 727 019 A1

800

For each check node $c$, it receives LLR messages from its neighbors $v_i \in \mathcal{N}(c)$

FIG. 8A

802

$$L_{c \to v_j} = \boxplus_{v_i \in \mathcal{N}(c) \setminus v_j} L_{v_i \to c}$$

$$= 2 \tanh^{-1}\left( \prod_{v_i \in \mathcal{N}(c) \setminus v_j} \tanh \frac{L_{v_i \to c}}{2} \right)$$

804

FIG. 8B

806

$$L_{v \to c_j} = a$$

$$= L_{prior} + \sum_{i \in \mathcal{N}(v) \setminus j} L_{c_i \to v}$$

808

FIG. 9

**FIG. 10**

1100

FIG. 11A

FIG. 11B

EP 4 727 019 A1

FIG. 12A   FIG. 12B

EP 4 727 019 A1

1300

Identifying a low-density parity-check (LDPC) code corresponding to a bipartite graph comprising a set of edges connected between a first set of nodes and a second set of nodes, wherein the LDPC code is generated using a first LDPC code associated with a first subset of the second set of nodes and a second LDPC code associated with a second subset of the second set of nodes 1302

Generating, using the encoded data, a first set of messages and a second set of messages 1304

Communicating, using the bipartite graph, the first set of messages with the first subset and the second set of messages with the second subset, concurrently 1306

Identifying decoded data based at least on processing of the first set of messages and the second set of messages 1308

FIG. 13

**EUROPEAN SEARCH REPORT**

Application Number

EP 25 20 7553

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SAMEER VERMANI (QUALCOMM): "Longer LDPC Codeword", IEEE DRAFT; 11-23-1985-00-00BN-LONGER-LDPC-CODEWORD, IEEE-SA MENTOR, PISCATAWAY, NJ USA , vol. 802.11 UHR; 802.11bn 12 May 2024 (2024-05-12), pages 1-26, XP068303567, Retrieved from the Internet: URL:https://mentor.ieee.org/802.11/dcn/23/11-23-1985-00-00bn-longer-ldpc-codeword.pptx [retrieved on 2024-05-12] * Slides 2-4, 8, 11-14 * | 1-14 | INV. H03M13/11 H03M13/00 |
| T | Krishnamurthy Akshay: "Lecture 25: LDPC Codes and Belief Propagation", Information Processing and Learning, 21 June 2015 (2015-06-21), pages 1-5, XP093360718, Retrieved from the Internet: URL:https://www.cs.cmu.edu/~aarti/Class/10704_Spring15/lecs/lec25.pdf | | |
| A | US 7 552 097 B2 (QUALCOMM INC [US]) 23 June 2009 (2009-06-23) * the whole document * | 1-14 | |
| A | US 11 929 761 B1 (ULRIKSSON BENGT ANDERS [US]) 12 March 2024 (2024-03-12) * the whole document * | 1-14 | |

TECHNICAL FIELDS SEARCHED (IPC)

H03M

The present search report has been drawn up for all claims

| Place of search | Date of completion of the search | Examiner |
|---|---|---|
| The Hague | 6 February 2026 | Belardinelli, Carlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 4 727 019 A1

## ANNEX TO THE EUROPEAN SEARCH REPORT
## ON EUROPEAN PATENT APPLICATION NO.

EP 25 20 7553

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2026

| Patent document cited in search report | | Publication date | Patent family member(s) | | Publication date |
|---|---|---|---|---|---|
| US 7552097 | B2 | 23-06-2009 | AT | E514231 T1 | 15-07-2011 |
| | | | CN | 1531708 A | 22-09-2004 |
| | | | EP | 1407420 A1 | 14-04-2004 |
| | | | EP | 2264907 A2 | 22-12-2010 |
| | | | ES | 2516765 T3 | 31-10-2014 |
| | | | JP | 4109191 B2 | 02-07-2008 |
| | | | JP | 2004531972 A | 14-10-2004 |
| | | | TW | I284460 B | 21-07-2007 |
| | | | US | 2003033575 A1 | 13-02-2003 |
| | | | US | 2005278606 A1 | 15-12-2005 |
| | | | US | 2006242093 A1 | 26-10-2006 |
| | | | WO | 02103631 A1 | 27-12-2002 |
| US 11929761 | B1 | 12-03-2024 | NONE | | |

EPO FORM P0459

For more details about this annex : see Official Journal of the European Patent Office, No. 12/82

33

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **RICHARDSON** ; **URBANKE**. *IEEE Transactions on Information Theory*, February 2001, vol. 47 (2)